# EUROPEAN PATENT APPLICATION

(11) **EP 4 624 968 A2**
(43) Date of publication of application: **01.10.2025**
(21) Application number: 25161979.7
(22) Date of filing: 06.03.2025
(51) Int. Cl.: G01R 33/00

(54) **MAGNETIC SENSOR**

(30) Priority: 28.03.2024 JP 2024053426
(71) Applicant: TDK Corporation, Tokyo 103-6128 (JP)
(72) Inventor: HARAKAWA, Osamu, 4024 Laguna (PH); AKUSHICHI, Taiju, 4024 Laguna (PH); BONSOL, Jonnie, 4024 Laguna (PH); OPERARIO, Daniel, 4024 Laguna (PH)
(74) Representative: Epping - Hermann - Fischer

(57) **Abstract**

Disclosed herein is a magnetic sensor that includes a housing, a magnetic sensor module accommodated in the housing, and an insulating dummy substrate. The magnetic sensor module including: an insulating substrate having upper and lower surfaces; a sensor chip mounted on the upper surface of the substrate; a terminal electrode provided on the upper surface of the substrate; a wiring pattern provided on the lower surface of the substrate; a first through hole conductor penetrating the substrate and connecting one end of the wiring pattern and the terminal electrode; and a second through hole conductor penetrating the substrate and connecting another end of the wiring pattern and the sensor chip. The dummy substrate is disposed between an inner wall of the housing and the lower surface of the substrate.

## Description

### BACKGROUND OF THE ART

### --Field of the Art

The present disclosure relates to a magnetic sensor and, more particularly, to a magnetic sensor accommodating a magnetic sensor module in a housing thereof.

### --Description of Related Art

The specification of International Publication WO 2023/145064 discloses a magnetic sensor accommodating a magnetic sensor module in a housing thereof.

Magnetic sensors of such a type have such a disadvantage that, at the time when the magnetic sensor module is assembled and accommodated in the housing, external static electricity is transferred to a sensor chip mounted in the magnetic sensor module to potentially break a magnetosensitive element on the sensor chip.

### SUMMARY

The present disclosure describes a technology for preventing, in a magnetic sensor accommodating a magnetic sensor module in a housing thereof, the breakage of a magnetosensitive element at the time when the magnetic sensor module is assembled and accommodated in the housing.

A magnetic sensor according to an aspect of the present disclosure includes: a housing; a magnetic sensor module accommodated in the housing; and an insulating dummy substrate. The magnetic sensor module includes: an insulating substrate having upper and lower surfaces; a sensor chip mounted on the upper surface of the substrate; a terminal electrode provided on the upper surface of the substrate; a wiring pattern provided on the lower surface of the substrate; a first through hole conductor penetrating the substrate and connecting one end of the wiring pattern and the terminal electrode; and a second through hole conductor penetrating the substrate and connecting the other end of the wiring pattern and the sensor chip. The dummy substrate is disposed between the inner wall of the housing and the lower surface of the substrate.

The present disclosure provides a technology for preventing, in a magnetic sensor accommodating a magnetic sensor module in a housing thereof, the breakage of a magnetosensitive element at the time when the magnetic sensor module is assembled and accommodated in the housing.

### BRIEF DESCRIPTION OF THE DRAWINGS

The above features and advantages of the present disclosure will be more apparent from the following description of some embodiments taken in conjunction with the accompanying drawings, in which:
FIG. 1 is a schematic perspective view illustrating the outer appearance of a magnetic sensor S according to an embodiment of the present disclosure;
FIG. 2 is a schematic exploded perspective view of the magnetic sensor S;
FIG. 3 is a schematic perspective view illustrating the outer appearances of the magnetic sensor module 1 and dummy substrate 4;
FIG. 4 is a schematic exploded perspective view of the magnetic sensor module 1 and dummy substrate 4;
FIGS. 5A and 5B are plan views for explaining the structure of the substrate 10 in more detail;
FIG. 6 is a schematic perspective view of the sensor chip 100;
FIG. 7 is a schematic plan view of the sensor chip 100;
FIG. 8 is a schematic cross-sectional view taken along the line A-A in FIG. 7; and
FIG. 9 is a circuit diagram of the magnetic sensor module 1.

### DETAILED DESCRIPTION OF THE EMBODIMENTS

Some embodiments of the present disclosure will be explained below in detail with reference to the accompanying drawings.

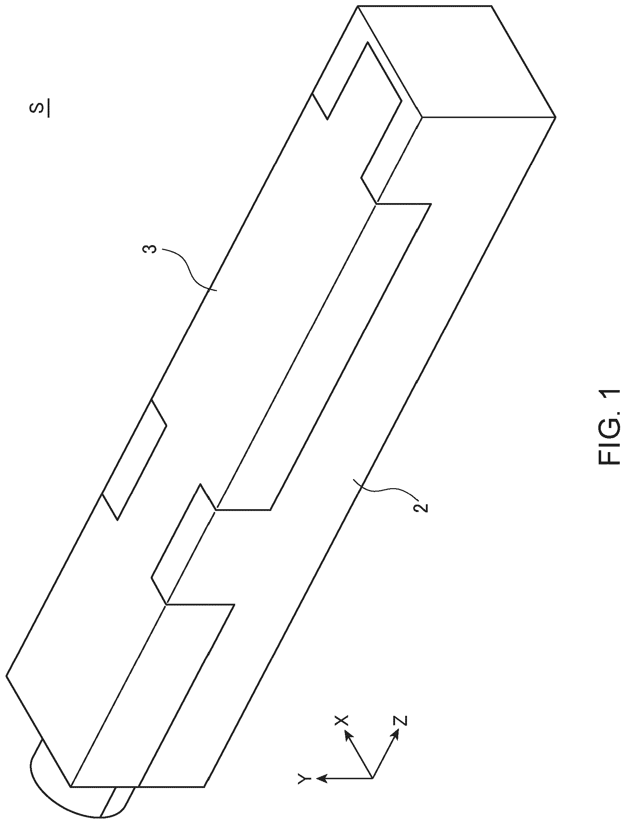

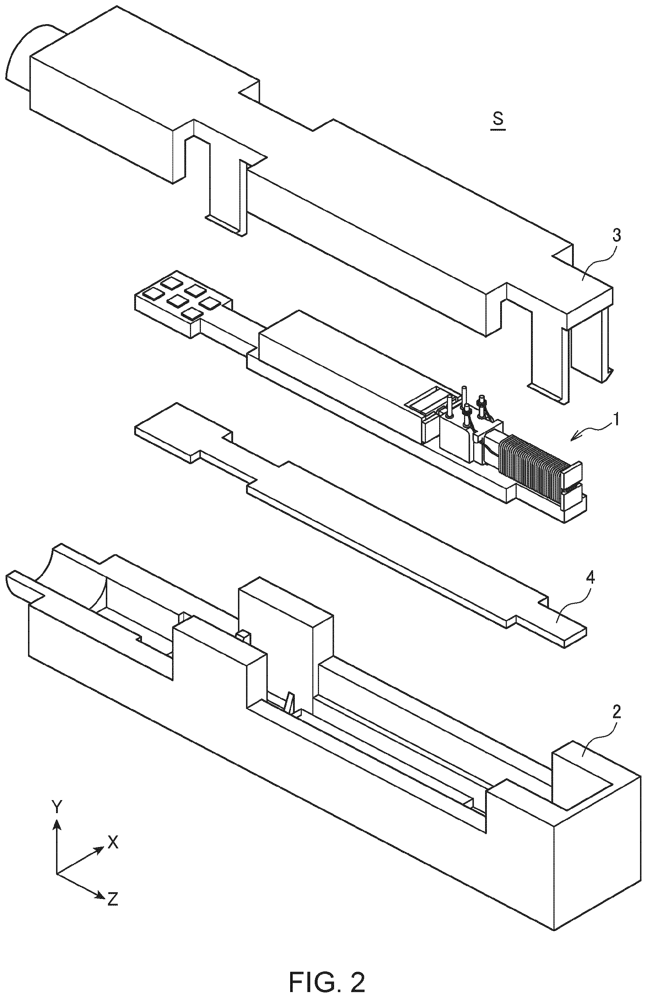

FIG. 1 is a schematic perspective view illustrating the outer appearance of a magnetic sensor S according to an embodiment of the present disclosure. FIG. 2 is a schematic exploded perspective view of the magnetic sensor S.

As illustrated in FIGS. 1 and 2, the magnetic sensor S according to the present embodiment includes a magnetic sensor module 1 which is the main body part thereof, housings 2 and 3 accommodating the magnetic sensor module 1, and a dummy substrate 4. The housings 2 and 3 serve lower and upper cases, respectively, and are each made of a composite material obtained by adding a conductive member such as carbon fiber to an insulating material such as polycarbonate. The housings 2 and 3 are fitted to each other in the Y-direction to form an internal space and accommodate the magnetic sensor module 1 and dummy substrate 4 inside the thus-formed internal space. The magnetic sensor S has a bar-like shape elongated in the Z-direction, and the end portion thereof in the positive Z-direction constitutes a sensor head. From the end portion of the magnetic sensor S in the negative Z-direction, a not-shown wire connected to the magnetic sensor module 1 is led out. When the housings 2 and 3 are made of the above-mentioned composite material, they themselves have conductivity. This makes static electricity unlikely to be accumulated inside the housings 2 and 3.

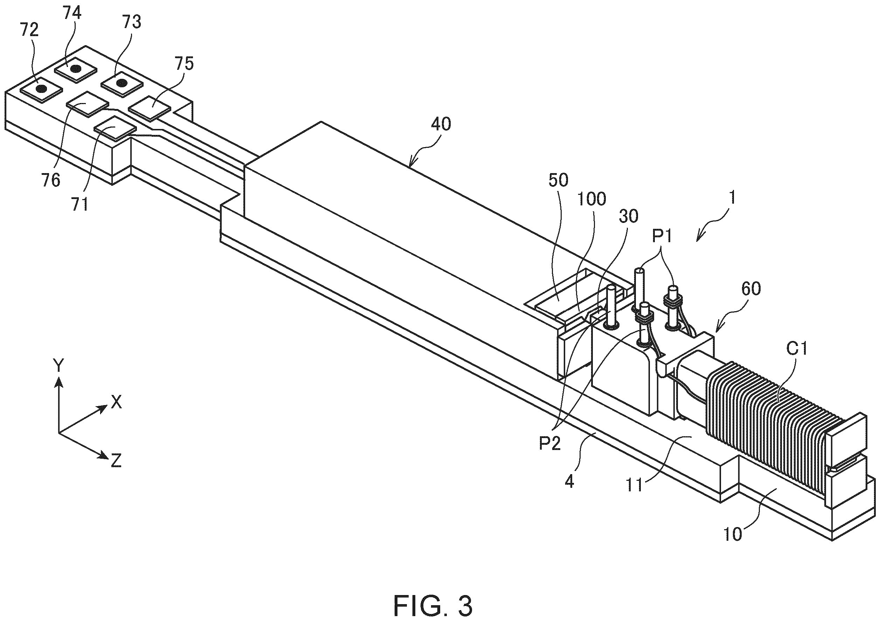

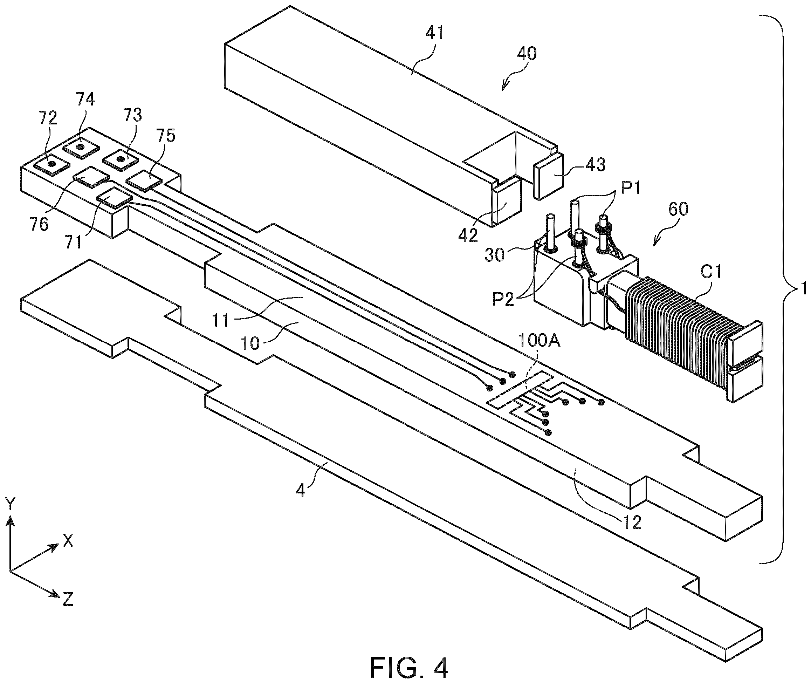

FIG. 3 is a schematic perspective view illustrating the outer appearances of the magnetic sensor module 1 and dummy substrate 4. FIG. 4 is a schematic exploded perspective view of the magnetic sensor module 1 and dummy substrate 4.

As illustrated in FIG. 3, the magnetic sensor module 1 includes a substrate 10 made of an insulating material, a sensor chip 100 mounted on an upper surface 11 (XZ surface) of the substrate 10, a magnetism collecting bodies 30 and 40, an auxiliary chip 50, and a molded member 60. The sensor chip 100 and auxiliary chip 50 are not illustrated in FIG. 4; instead, a mounting area 100A of the sensor chip 100 is denoted by a dashed line.

The magnetism collecting bodies 30 and 40, which are provided for collecting magnetic flux in the sensor chip 100, each have a bar-like shape elongated in the Z-direction and made of a high permeability material such as ferrite. The sensor chip 100 is disposed between the magnetism collecting bodies 30 and 40, whereby a magnetic field in the Z-direction is selectively collected, and the collected magnetic field is applied to the sensor chip 100. The magnetism collecting body 40 includes a main body part 41 elongated in the Z-direction and a pair of overhung parts 42 and 43 protruding from end portions of the main body part 41 and constituting the XY plane.

The magnetism collecting body 30 may be wound with a compensation coil C1 through the molded member 60. The compensation coil C1 has its coil axis extending in the Z-direction. The molded member 60 is made of a nonmagnetic insulating material such as resin and is fixed to the magnetism collecting body 30 through an adhesive or the like. The molded member 60 retains U-shaped pins P1 and P2. One end of the pin P1 is fixed with one end of the compensation coil C1, and one end of the pin P2 is fixed with the other end of the compensation coil C1. The compensation coil C1 is optional, and the other ends of the pins P1 and P2 are opened in the example illustrated in FIGS. 3 and 4. When the compensation coil C is used, wires are connected to the other ends of the pins P1 and P2, allowing a compensation current to flow through the compensation coil C1.

A lower surface 12 constituting the XZ surface of the substrate 10 is covered with the dummy substrate 4 made of an insulating material. That is, the dummy substrate 4 is disposed between the inner wall of the housing 2 constituting a lower case and the lower surface 12 of the substrate 10. The dummy substrate 4 may be made of the same insulating material as the substrate 10 or different insulating material from the substrate 10. When the same material is used for the dummy substrate 4 and substrate 10, material cost can be reduced. Further, the XZ plane shapes of the dummy substrate 4 and substrate 10 may be mutually the same or different. When the dummy substrate 4 and substrate 10 have the same XZ plane shape, processing cost can be reduced.

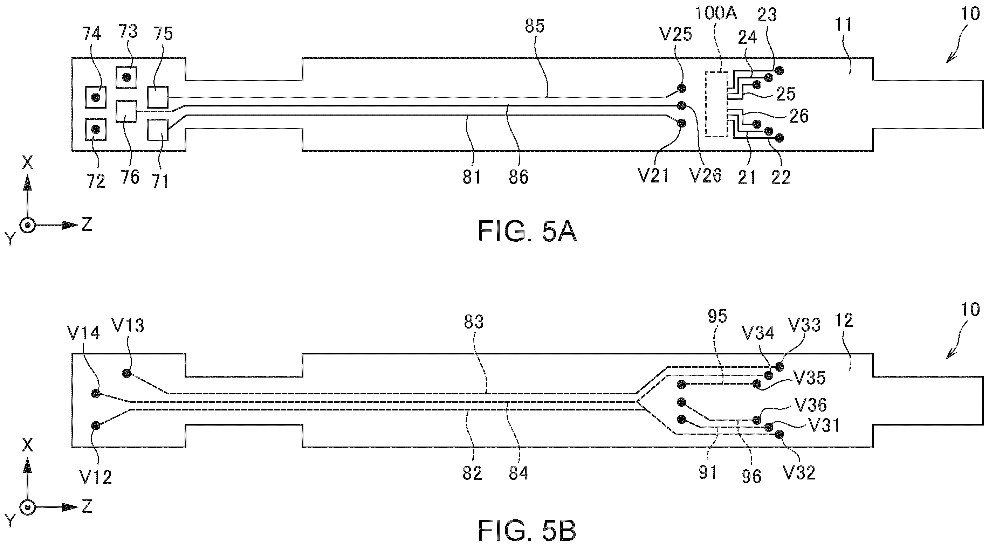

FIGS. 5A and 5B are plan views for explaining the structure of the substrate 10 in more detail. FIG. 5A illustrates the upper surface 11 of the substrate 10 as viewed in the positive Y-direction, and FIG. 5B illustrates the lower surface 12 of the substrate 10 as viewed in the positive Y-direction transparently through the substrate 10.

As illustrated in FIG. 5, terminal electrodes 71 to 76 are provided on the upper surface 11 of the substrate 10. The terminal electrodes 71, 75, and 76 are respectively connected to one ends of wiring patterns 81, 85, and 86 provided on the upper surface 11 of the substrate 10. The other ends of the wiring patterns 81, 85, and 86 are respectively connected to one ends of wiring patterns 91, 95, and 96 provided on the lower surface 12 of the substrate 10 through the through hole conductors V21, V25, and V26 penetrating the substrate 10. The other ends of the wiring patterns 91, 95, and 96 are respectively connected to one ends of wiring patterns 21, 25, and 26 provided on the upper surface 11 of the substrate 10 through the through hole conductors V31, V35, and V36 penetrating the substrate 10.

On the other hand, the remaining terminal electrodes 72 to 74 are respectively connected to one ends of wiring patterns 82 to 84 provided on the lower surface 12 of the substrate 10 through the through hole conductors V12 to V14 penetrating the substrate 10. The other ends of the wiring patterns 82 to 84 are respectively connected to one ends of wiring patterns 22 to 24 provided on the upper surface 11 of the substrate 10 through the through hole conductors V32 to V34 penetrating the substrate 10. The other ends of the wiring patterns 21 to 26 are connected to the sensor chip 100.

The wiring patterns 21 to 26 and 81 to 86 provided on the upper surface 11 of the substrate 10 and the wiring patterns 91, 95, and 96 provided on the lower surface 12 of the substrate 10 are all covered with an insulating member such as a solder resist, whereas the end portions of the through hole conductors V12 to V14, V21, V25, V26, and V31 to V36 are all exposed to the outside without being covered with an insulating member such as a solder resist.

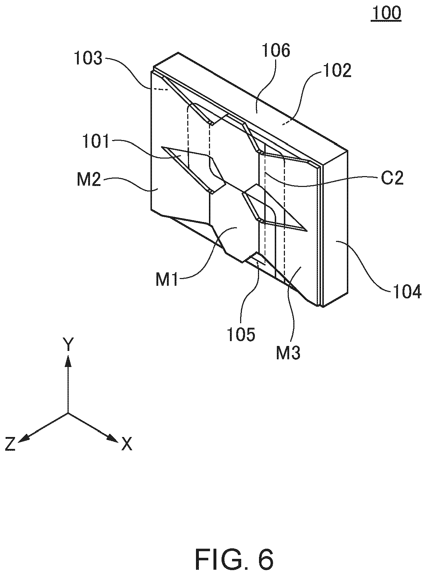

FIG. 6 is a schematic perspective view of the sensor chip 100.

As illustrated in FIG. 6, the sensor chip 100 has an element formation surface 101, a back surface 102, and side surfaces 103, 104, 105, and 106. The element formation surface 101 and back surface 102 constitute the XY surface and positioned on the mutually opposite sides. The side surfaces 103 and 104 constitute the YZ surface and positioned on the mutually opposite sides. The side surfaces 105 and 106 constitute the XZ surface and positioned on the mutually opposite sides. There are formed, on the element formation surface 101 of the sensor chip 100, magnetosensitive elements (to be described later) and magnetic layers M1 to M3 (to be described later). The back surface 102 of the sensor chip 100 is covered with the auxiliary chip 50, whereby the mechanical strength of the sensor chip 100 is enhanced.

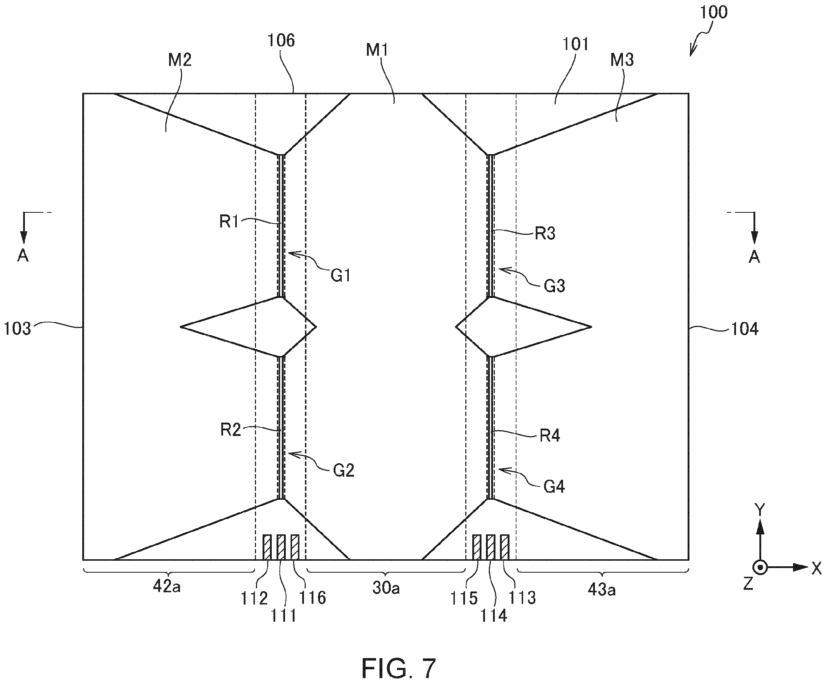

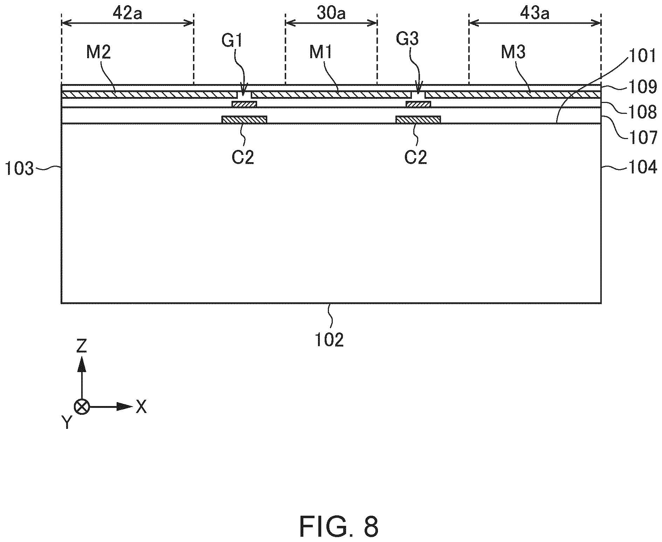

FIG. 7 is a schematic plan view of the sensor chip 100, and FIG. 8 is a schematic cross-sectional view taken along the line A-A in FIG. 7.

As illustrated in FIGS. 7 and 8, four magnetosensitive elements R1 to R4 are formed on the element formation surface 101 of the sensor chip 100. The magnetosensitive elements R1 to R4 are not particularly limited in type as long as they are elements whose electric resistance varies depending on the direction of magnetic flux and may be, for example, an MR element. The fixed magnetization directions of the magnetosensitive elements R1 to R4 are the same direction (for example, positive X-direction). The magnetosensitive elements R1 to R4 are formed on the surface of an insulating layer 107 covering the element formation surface 101. The magnetosensitive elements R1 to R4 are covered with an insulating layer 108, on the surface of which magnetic layers M1 to M3 made of permalloy or the like are formed. The magnetic layers M1 to M3 are covered with an insulating layer 109. The magnetic layer M1 is disposed at substantially the center of the element formation surface 101 in the X-direction. The magnetic layers M2 and M3 are disposed at both sides of the element formation surface 101 in the X-direction so as to sandwich the magnetic layer M1 in the X-direction.

The magnetic layers M1 and M2 form two gaps G1 and G2 each having a width in the X-direction and extending in the Y-direction. The gaps G1 and G2 are at the same X-direction position and arranged in the Y-direction. The magnetic layers M1 and M3 form two gaps G3 and G4 having a width in the X-direction and extending in the Y-direction. The gaps G3 and G4 are at the same X-direction position and arranged in the Y-direction. The gaps G1 and G3 are arranged in the X-direction, and the gaps G2 and G4 are arranged in the X-direction. The magnetosensitive elements R1 to R4 are disposed at positions overlapping the gaps G1 to G4, respectively, in a plan view (as viewed in the Z-direction). With this configuration, magnetic fields in the X-direction passing through respective magnetic gaps G1 to G4 are applied respectively to the magnetosensitive elements R1 to R4.

In FIGS. 7 and 8, reference numeral 30a denotes an area covered in the Z-direction with the XY surface of the magnetism collecting body 30 positioned at one end in the Z-direction, and reference numerals 42a and 43a respectively denote areas covered in the Z-direction with the overhung parts 42 and 43 of the magnetism collecting body 40. Further, terminal electrodes 111 to 116 are provided in areas of the element formation surface 101 of the sensor chip 100 that are not covered with the magnetism collecting body 30 or 40. The terminal electrodes 111 to 116 are connected respectively to the wiring patterns 21 to 26 illustrated in FIG. 5A.

The areas 30a, 42a, and 43a respectively overlap the magnetic layers M1 to M3. Thus, the magnetic layer M1 is covered with the magnetism collecting body 30 in the Z-direction, the magnetic layer M2 is covered with the overhung part 42 of the magnetism collecting body 40 in the Z-direction, and the magnetic layer M3 is covered with the overhung part 43 of the magnetism collecting body 40 in the Z-direction. Then, a magnetic field in the Z-direction (magnetic field to be detected) is collected by the magnetism collecting body 30 and applied to the magnetic layer M1 through the magnetism collecting body 30. The magnetic field thus applied to the magnetic layer M1 is curved in the positive and negative X-directions in the magnetic layer M1. Magnetic flux components curved in the negative X-direction in the magnetic layer M1 are supplied to the magnetic layer M2 through the gaps G1 and G2 and then flow to the main body part 41 of the magnetism collecting body 40 through the overhung part 42 thereof. At this time, a part of the magnetic flux that passes through the gaps G1 and G2 in the negative X-direction is applied to the magnetosensitive elements R1 and R2. On the other hand, magnetic flux components curved in the positive X-direction in the magnetic layer M1 are supplied to the magnetic layer M3 through the gaps G3 and G4 and then flow to the main body part 41 of the magnetism collecting body 40 through the overhung part 43 thereof. At this time, a part of the magnetic flux that passes through the gaps G3 and G4 in the positive X-direction is applied to the magnetosensitive elements R3 and R4.

As illustrated in FIGS. 6 and 8, a compensation coil C2 is provided in the sensor chip 100. For example, the compensation coil C2 is disposed at a position overlapping the magnetosensitive elements R1 to R4. When a current flows through the compensation coil C2, a canceling magnetic field is applied to the magnetosensitive elements R1 to R4. In the example illustrated in **FIG.** 8, the compensation coil C2 is provided on the element formation surface 101.

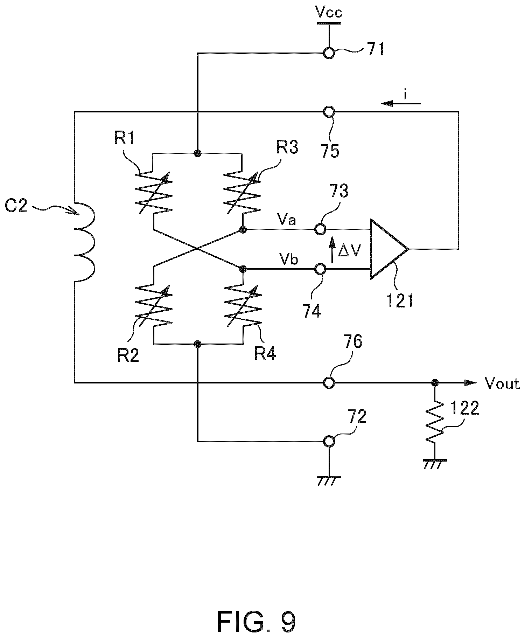

FIG. 9 is a circuit diagram of the magnetic sensor module 1.

As illustrated in FIG. 9, the magnetosensitive elements R1 to R4 are bridge-connected between the terminal electrode 71 supplied with a power supply Vcc and the terminal electrode 72 grounded to a ground GND. That is, the magnetosensitive elements R1 and R4 are connected in series between the power supply Vcc and the ground GND, and the magnetosensitive elements R3 and R2 are connected in series between the power supply Vcc and the ground GND. The connection point between the magnetosensitive elements R2 and R3 is connected to the terminal electrode 73, and the connection point between the magnetosensitive elements R1 and R4 is connected to the terminal electrode 74. A potential difference between a potential Va appearing at the terminal electrode 73 and a potential Vb appearing at the terminal electrode 74 is used as an output signal ΔV (Va - Vb). As described above, the magnetosensitive elements R1 to R4 constitute a differential bridge circuit, and a change in the electrical resistance of the magnetosensitive elements R1 to R4 according to a magnetic flux density appears as the level of the output signal ΔV.

The output signal ΔV is supplied to an operation amplifier 121. A compensation current i output from the operation amplifier 121 is supplied to the terminal electrode 75. The terminal electrode 75 is connected to one end of the compensation coil C2, and the terminal electrode 76 is connected to the other end of the compensation coil C2. Thus, the compensation current i output from the operation amplifier 121 is supplied to the compensation coil C2. The compensation coil C2 is integrated in the sensor chip 100 in a manner as illustrated in FIGS. 6 and 8. When the compensation current i output from the operation amplifier 121 flows through the compensation coil C2, a canceling magnetic field is generated. Thus, when the output signal ΔV corresponding to the magnetic flux density of a magnetic field to be detected is generated, the compensation current i of a corresponding level flows through the compensation coil C2 to generate a canceling magnetic field in the opposite direction, with the result that the magnetic field to be detected to be applied to the magnetosensitive elements R1 to R4 is canceled on the sensor chip 100. Then, the compensation current i is current-voltage converted by a resistor 122 to generate an output signal Vout, whereby the strength of the magnetic field to be detected can be detected.

In place of the compensation coil C2 integrated in the sensor chip 100, the compensation coil C1 illustrated in FIGS. 3 and 4 may be used. In this case, the both ends of the compensation coil C1 are connected respectively to the terminal electrodes 75 and 76.

As described above, in the magnetic sensor S according to the present embodiment, the dummy substrate 4 made of an insulating material is disposed between the lower surface 12 of the substrate 10 included in the magnetic sensor module 1 and the housing 2 serving as the lower case. Thus, even when the end portions of the through hole conductors V12 to V14, V21, V25, V26, V31 to V36 are exposed to the lower surface 12 of the substrate 10, they do not contact the housing 2, so that, at the time when the magnetic sensor module 1 is assembled and accommodated in the housings 2 and 3, external static electricity is unlikely to be transferred from the housing 2 to the sensor chip 100 through the through hole conductors V12 to V14, V21, V25, V26, V31 to V36. That is, even when static electricity intrudes into the magnetic sensor S through the housing 2 having slight conductivity as an intrusion passage, it is insulated by the dummy substrate 4 and is thus unlikely to be transferred to the sensor chip 100.

To effectively prevent conduction of static electricity through the housing 2 and through hole conductors V12 to V14, V21, V25, V26, V31 to V36, the thickness of the dummy substrate 4 may be set equal to or more than 0.45 mm. Thus, even when ± 8kV atmospheric discharge (in accordance with IEC-61326-1) is performed for the housing 2, the magnetosensitive elements R1 to R4 are not damaged. The insulating effect obtained by the dummy substrate 4 becomes higher as the dummy substrate 4 is thicker; however, the dummy substrate 4 need not have a thickness comparable to the thickness (e.g., 1.2 mm) required for the substrate 10 and may thus be smaller in thickness than the substrate 10. This can minimize an increase in the thickness of the magnetic sensor module 1 in the Y-direction.

As described above, in the magnetic sensor S according to the present embodiment, the dummy substrate 4 is provided between the magnetic sensor module 1 and the housing **2,** so that it is possible to prevent breakage of a magnetosensitive element at the time of assembly.

While some embodiments of the technology according to the present disclosure have been described, the technology according to the present disclosure is not limited to the above embodiments, and various modifications may be made within the scope of the present disclosure, and all such modifications are included in the technology according to the present disclosure.

The technology according to the present disclosure includes the following configuration examples, but not limited thereto.

A magnetic sensor according to an aspect of the present disclosure includes: a housing; a magnetic sensor module accommodated in the housing; and an insulating dummy substrate. The magnetic sensor module includes: an insulating substrate having upper and lower surfaces; a sensor chip mounted on the upper surface of the substrate; a terminal electrode provided on the upper surface of the substrate; a wiring pattern provided on the lower surface of the substrate; a first through hole conductor penetrating the substrate and connecting one end of the wiring pattern and the terminal electrode; and a second through hole conductor penetrating the substrate and connecting the other end of the wiring pattern and the sensor chip. The dummy substrate is disposed between the inner wall of the housing and the lower surface of the substrate. With this configuration, external static electricity is unlikely to be transferred to the sensor chip through the through hole conductor at the time when the magnetic sensor module is assembled and accommodated in the housing.

In the above magnetic sensor, the substrate and the dummy substrate may be made of the same insulating material. This can reduce material cost.

In the above magnetic sensor, the substrate and the dummy substrate may have the same planar shape. This can reduce processing cost.

In the above magnetic sensor, the thickness of the dummy substrate may be 0.45 mm or more. This prevents damage of the sensor chip even when high-voltage discharge occurs at the time of assembly.

In the above magnetic sensor, the thickness of the dummy substrate may be smaller than the thickness of the substrate. This can suppress an increase in the thickness of the magnetic sensor module.

In the above magnetic sensor, the housing may have conductivity. This makes static electricity unlikely to be accumulated inside the housing.

## Claims

1. A magnetic sensor comprising:
a housing;
a magnetic sensor module accommodated in the housing; and
an insulating dummy substrate,
wherein the magnetic sensor module includes:
an insulating substrate having upper and lower surfaces;
a sensor chip mounted on the upper surface of the substrate;
a terminal electrode provided on the upper surface of the substrate;
a wiring pattern provided on the lower surface of the substrate;
a first through hole conductor penetrating the substrate and connecting one end of the wiring pattern and the terminal electrode; and
a second through hole conductor penetrating the substrate and connecting another end of the wiring pattern and the sensor chip, and
wherein the dummy substrate is disposed between an inner wall of the housing and the lower surface of the substrate.

2. The magnetic sensor as claimed in claim 1, wherein the substrate and the dummy substrate are made of a same insulating material.

3. The magnetic sensor as claimed in claim 1, wherein the substrate and the dummy substrate have a same planar shape.

4. The magnetic sensor as claimed in claim 1, wherein a thickness of the dummy substrate is 0.45 mm or more.

5. The magnetic sensor as claimed in claim 1, wherein a thickness of the dummy substrate is smaller than a thickness of the substrate.

6. The magnetic sensor as claimed in any one of claims 1 to 5, wherein the housing has conductivity.
